# EUROPÄISCHE PATENTSCHRIFT

(11) **EP 2 815 638 B1**
(45) Veröffentlichungstag und Bekanntmachung des Hinweises auf die Patenterteilung: **24.08.2016**
(21) Anmeldenummer: 13713900.2
(22) Anmeldetag: 03.04.2013
(51) Int. Cl.: H05K 7/20, H01L 23/467, B06B 3/00, H01L 23/473

(54) **KÜHLVORRICHTUNG**
COOLING DEVICE
DISPOSITIF DE REFROIDISSEMENT

(30) Priorität: 03.04.2012 DE 102012205463; 31.08.2012 DE 102012215484
(43) Veröffentlichungstag der Anmeldung: 24.12.2014
(73) Patentinhaber: Siemens Aktiengesellschaft, 80333 München (DE)
(72) Erfinder: HONSBERG-RIEDL, Martin, 83317 Teisendorf (DE); LÖSCHKE, Jakob, 80805 München (DE); MITIC, Gerhard, 81827 München (DE); MOCK, Randolf, 85662 Hohenbrunn (DE); VONTZ, Thomas, 81539 München (DE)
(86) Internationale Anmeldenummer: PCT/EP2013/057022
(87) Internationale Veröffentlichungsnummer: WO 2013/150071

(56) Entgegenhaltungen:
- DE-A1-102011 087 484

## Beschreibung

Die Erfindung betrifft eine Kühlvorrichtung zum Kühlen eines elektronischen Bauteils, insbesondere eines Leistungshalbleiters.

Zum Kühlen thermisch anspruchsvoller elektronischer Komponenten, wie beispielsweise von Leistungshalbleitern, reicht oftmals eine passiv-konvektive Kühlung unter Zuhilfenahme eines Kühlkörpers nicht aus. Es ist in solchen Fällen daher notwendig, zusätzlich aktiv eine auf den Kühlkörper gerichtete Luftströmung zu erzeugen.

Neben der Verwendung mechanischer Lüfter, die sowohl laut als auch verschleißanfällig sind, ist hierfür auch die Verwendung von Ultraschallwandlern bekannt. Solche Wandler, beispielsweise piezoelektrische Sonotroden, erzeugen neben der eigentlichen Ultraschallschwingung auch einen vom Wandler weg gerichteten Luftstrom, der sogenannte Ultraschallwind, der zur aktiven Kühlung genutzt werden kann.

Verglichen mit mechanischen Lüftern wird mit Ultraschallwandlern jedoch nur ein relativ geringer Luftdurchsatz erzeugt.

Es ist daher Aufgabe der vorliegenden Erfindung, eine verbesserte Kühlvorrichtung bereitzustellen, welche einen verbesserten Wärmeabtransport von elektronischen Bauelementen ermöglicht und insbesondere einen erhöhten Luftdurchsatz erzeugt.

DE 10 2011 087 484 A1 zeigt eine Transformationssonotrode (3) welche durch einen Hohlzylinder dargestellt ist, der sich von einer ersten Stirnfläche (12, 13) zu einer zweiten Stirnfläche (17, 18) verjüngt, wobei zur Aufnahme von mechanischen Schwingungen der Hohlzylinder an einer ersten Stirnfläche (12, 13) mit einem elektromechanischen Wandler (1, 2) koppelbar ist, zur Übertragung und Verstärkung der mechanischen Schwingungen im Bereich einer gegenüberliegenden zweiten Stirnfläche (17, 18) mit einer Sonotrode koppelbar ist, wobei der Hohlzylinder am verjüngten Ende nach innen gestülpt ist, sodass beide Stirnflächen (12, 17, 13, 18) etwa in die gleiche Richtung weisen.

Diese Aufgabe wird durch eine Kühlvorrichtung mit den Merkmalen des Patentanspruchs 1, mit einer Kühlvorrichtung mit den Merkmalen des Patentanspruchs 2 sowie mit einer Kühlvorrichtung mit den Merkmalen des Patentanspruchs 8 gelöst. Bevorzugte Weiterbildungen der Erfindung ergeben sich aus den zugehörigen Unteransprüchen, der nachfolgenden Beschreibung und der Zeichnung.

Die erfindungsgemäße Kühlvorrichtung ist zum Kühlen eines elektronischen Bauelements, insbesondere eines Leistungshalbleiters, ausgebildet. Sie weist zumindest ein Sonotrodenelement zur Erzeugung von Ultraschallwellen einer vorgegebenen Wellenlänge auf. Ferner weist die erfindungsgemäße Kühlvorrichtung ein dem Sonotrodenelement zugeordnetes Resonanzrohr mit einem ersten geöffneten Ende und einem zweiten geöffneten Ende auf. Bei der erfindungsgemäßen Kühlvorrichtung ist das Sonotrodenelement dem ersten Ende näher als dem zweiten Ende des Resonanzrohres angeordnet oder aber das erste Ende weist zum Sonotrodenelement hin. Der Abstand von Sonotrode und zweitem Ende und/oder von erstem Ende und zweitem Ende entspricht im Wesentlichen einem ganzzahligen Vielfachen der halben Wellenlänge. Alternativ oder zusätzlich zum jeweiligen Abstand entspricht der Strömungsweg zwischen Sonotrode und zweitem Ende und/oder der Strömungsweg zwischen erstem Ende und zweitem Ende durch das Resonanzrohr hindurch im Wesentlichen einem ganzzahligen Vielfachen der halben Wellenlänge.

Es versteht sich, dass ein im Wesentlichen einem ganzzahligen Vielfachen der halben Wellenlänge entsprechender Abstand oder Strömungsweg geringfügig, d.h. insbesondere um höchstens ein Achtel, vorzugsweise um höchstens ein Sechzehntel der Wellenlänge, von dem ganzzahligen Vielfachen der halben Wellenlänge abweichen kann. Idealerweise betragen die Abweichungen von dem ganzzahligen Vielfachen der halben Wellenlänge höchstens ein Zweiunddreißigstel der Wellenlänge. Besonders bevorzugt entspricht der Abstand oder der Strömungsweg im Rahmen der Fertigungstoleranz genau einem ganzzahligen Vielfachen der halben Wellenlänge.

Aufgrund dieser geometrischen Anordnung bildet sich am zweiten Ende des Resonanzrohres ein Wellenbauch der durch das Sonotrodenelement resonant angeregten stehenden Ultraschallwellen aus - zwischen dem Sonotrodenelement und dem zweiten Ende des Resonanzrohres oder zwischen dem ersten Ende und dem zweiten Ende des Resonanzrohres wird also eine stehende Welle erzeugt. Somit entsprechen beim erfindungsgemäßen Kühlkörper wie zuvor beschrieben die Schwingungsverhältnisse einer offenen Orgelpfeife.

Durch das im Resonanzrohr schwingende Ultraschallfeld wird am zweiten Ende des Resonanzrohres eine, verglichen mit resonanzrohrfreien Anordnungen, deutlich erhöhte Strömungsgeschwindigkeit der strömenden Luft erreicht. Folglich ist der Wärmeübergang eines nah dem zweiten Endes angeordneten Kühlkörpers an die strömende Luft deutlich verbessert.

Besonders zweckmäßig ist das erste Ende des Resonanzrohres von der Sonotrode um ein Vielfaches der halben Wellenlänge beabstandet, wobei zudem das erste und das zweite Ende des Resonanzrohres voneinander um ein Vielfaches der halben Wellenlänge voneinander beabstandet sind oder aber der Strömungsweg zwischen erstem und zweitem Ende ein Vielfaches der halben Wellenlänge beträgt. Auf diese Weise können sich zwischen erstem und zweitem Ende sowie zwischen Sonotrodenelement und zweitem Ende ausbildende Resonanzen vorteilhaft gegenseitig überlagern und verstärken.

Zweckmäßig ist bei der erfindungsgemäßen Kühlvorrichtung das Sonotrodenelement außerhalb des Resonanzrohres und/oder stirnseitig zu diesem angeordnet. Auf diese Weise kann das Sonotrodenelement besonders effizient Resonanzen im Resonanzrohr anregen.

Vorteilhaft umfasst die erfindungsgemäße Kühlvorrichtung ferner einen mit dem Bauelement koppelbaren Kühlkörper, welcher nah dem zweiten Ende des Resonanzrohres, insbesondere stirnseitig zu diesem und/oder außerhalb des Resonanzrohres, angeordnet ist. Die aus dem Resonanzrohr austretende, in ihrer Strömungsgeschwindigkeit gegenüber dem Stand der Technik deutlich erhöhte Luft kann so den Kühlkörper geeignet mit wärmeabführender Luft beströmen.

Bevorzugt ist bei der erfindungsgemäßen Kühlvorrichtung zwischen zweitem Ende des Resonanzrohres und dem Kühlkörper ein Luftspalt vorgesehen. Hierdurch wird ein Abströmen des durch den Ultraschallwind zugeführten Luftstromes ermöglicht.

Idealerweise entspricht bei der erfindungsgemäßen Kühlvorrichtung der Abstand zwischen dem Sonotrodenelement und dem zweiten Ende des Resonanzrohres und/oder zwischen dem ersten und dem zweiten Ende des Resonanzrohres und/oder der Strömungsweg zwischen Sonotrode und zweitem Ende des Resonanzrohres und/oder zwischen erstem und zweitem Ende des Resonanzrohres durch das Resonanzrohr hindurch einer halben und/oder einer und/oder anderthalb und/oder zwei und/oder zweieinhalb und/oder drei Wellenlänge/n. In der Praxis lassen sich auf diese Weise effizient Resonanzen anregen.

Zweckmäßigerweise entspricht bei der erfindungsgemäßen Kühlvorrichtung der Durchmesser des Resonanzrohres im Wesentlichen der Wellenlänge. Resonanzen lassen im Resonanzrohr sich in diesem Falle besonders einfach anregen.

Es versteht sich, dass ein im Wesentlichen der Wellenlänge entsprechender Durchmesser des Resonanzrohres von der Wellenlänge auch geringfügig, d.h. insbesondere um höchstens ein Achtel der Wellenlänge, vorzugsweise um höchstens ein Sechzehntel der Wellenlänge, abweichen kann. Idealerweise betragen die Abweichungen von dem ganzzahligen Vielfachen der halben Wellenlänge höchstens ein Zweiunddreißigstel der Wellenlänge.

Besonders bevorzugt weist bei der erfindungsgemäßen Kühlvorrichtung das erste Ende des Resonanzrohres eine Schneidkante auf. Mittels der Schneidkante kommt es beim Einlauf des Luftstroms wie bei einer Orgelpfeife zu einer Verstärkung des resonanten Effektes der Resonanzrohrströmung. Idealerweise wird durch die Geometrie der Schneidkante und/oder des ersten Endes des Resonanzrohres und/oder des Sonotrodenelements die Luftströmung derart kanalisiert, dass sie genau auf die Schneidkante trifft, insbesondere mittels des zumindest einen geeignet vorgesehenen Strömungsleitmittels.

In einer bevorzugten Weiterbildung der Erfindung ist dabei eine Wand des Resonanzrohrs am ersten Ende an ihrer Innenseite zur Längserstreckung des Resonanzrohres geschrägt, geeigneterweise derart, dass die Wand am ersten Ende oder zum ersten Ende hin spitz zuläuft.

Alternativ oder zusätzlich ist die Wand des ersten Endes des Resonanzrohres an ihrer Außenseite zur Längserstreckung des Resonanzrohres geschrägt, zweckmäßig derart, dass die Wand am ersten Ende oder zum ersten Ende hin spitz zuläuft.

In einer besonders bevorzugten Weiterbildung der Erfindung ist bei der Kühlvorrichtung zusätzlich ein Strömungsleitmittel vorgesehen, mittels welchem strömende Luft auf die Schneidkanten treffend leitbar ist.

Zweckmäßig ist das Strömungsleitmittel derart angeordnet und ausgebildet, dass das Strömungsleitmittel mindestens einen Strömungskanal aufweist, wobei die Querschnittsfläche des Strömungskanals nah der Schneidkante verringert ist. Zweckmäßig ist der Strömungskanal axial fluchtend mit dem Resonanzrohr angeordnet. Geeigneterweise ist der Strömungskanal an einem der Schneidkante fernen Ende nah dem Sonotrodenelement angeordnet.

Bevorzugt weist das Strömungsleitmittel mindestens ein Strömungsleitrohr sowie zumindest ein Strömungsbegrenzungsmittel auf, welches mit dem Strömungsleitrohr zumindest einen Strömungskanal bildend zusammenwirkt. Bevorzugt ist das Leitrohr axial fluchtend mit dem Resonanzrohr angeordnet. In einer zweckmäßigen Weiterbildung der Erfindung ist das Strömungsbegrenzungsmittel ein axial fluchtend mit dem Resonanzrohr angeordneter und innerhalb des Leitrohres liegender Trichter, Kegel oder Kegelstumpf, welcher sich längs der Längsachse des Strömungsleitrohres in Richtung auf das Resonanzrohr zu weitet und bevorzugt massiv ausgebildet ist. Auf diese Weise kann eine Austrittsöffnung des Strömungsleitrohres in radialer Richtung mit der Schneidkante überlappen. Eine besonders gute Beströmung der Schneidkante wird derart erreicht.

Der mit Ultraschallwandlern erzeugte Luftdurchsatz - und damit die Kühlleistung - kann durch geeignete Maßnahmen wie zuvor beschrieben verbessert werden.

Auch mit verstärktem Luftdurchsatz gemäß der erfindungsgemäßen Lösung wie zuvor beschreiben ist bei der aktiven Kühlung mit Ultraschallwandlern infolge der Ausbildung einer ruhenden Luftgrenzschicht an der Oberfläche des Kühlkörpers, der Wärmeübergang an den bewegten Luftstrom des Ultraschallwindes jedoch mitunter einschränkt.

Mittels der nachfolgend beschriebenen erfindungsgemäßen Kühlvorrichtung mit den in Anspruch 8 angegebenen Merkmalen, welche alternativ oder - zumindest soweit sie den zuvor beschriebenen Merkmalen nicht entsprechen - zusätzlich zu den Merkmalen der erfindungsgemäßen Kühlvorrichtung wie zuvor beschrieben vorhanden sein können, wird ein demgegenüber weiter verbesserter Wärmeabtransport von elektronischen Bauelementen ermöglicht:
Eine solche erfindungsgemäße Kühlvorrichtung zum Kühlen eines elektronischen Bauelements, insbesondere eines Leistungshalbleiters, umfasst einen thermisch mit dem Bauelement gekoppelten Kühlkörper, zumindest einem Sonotrodenelement zur Erzeugung von auf den Kühlkörper hin gerichteten Ultraschallwellen einer vorgegebenen Wellenlänge, sowie ein dem Sonotrodenelement zugeordnetes Resonanzrohr, welches zwischen dem Sonotrodenelement und dem Kühlkörper angeordnet ist.

Erfindungsgemäß ist dabei vorgesehen, dass ein Abstand zwischen dem Sonotrodenelement und dem Kühlkörper einem ganzzahligen Vielfachen eines Viertels der Wellenlänge entspricht. Aufgrund dieser geometrischen Anordnung bildet sich an der Oberfläche des Kühlkörpers ein Wellenknoten aus - zwischen dem Sonotrodenelement und dem Kühlkörper wird also eine stehende Welle erzeugt. Im Gegensatz zur vorbeschriebenen Anordnung entsprechen die Schwingungsverhältnisse somit nicht länger einer offenen, sondern einer gedackten Orgelpfeife.

Durch das schwingende Ultraschallfeld wird die Dicke der unbewegten Grenzschicht an der Kühlkörperoberfläche deutlich verringert, so dass der Wärmeübergang an die strömende Luft deutlich verbessert wird. Insbesondere können sich im Grenzschichtbereich Wirbel ausbilden, die den Wärmeaustausch zwischen Kühlkörper und Luft deutlich erleichtern, so dass die Kühleffizienz einer solchen Vorrichtung besonders gut ist.

In weiterer Ausgestaltung der Erfindung ist zwischen einem kühlkörperseitigen Ende des Resonanzrohres und dem Kühlkörper ein Luftspalt vorgesehen. Hierdurch wird ein Abströmen des durch den Ultraschallwind zugeführten Luftstromes ermöglicht. Die Spaltbreite kann dabei geeignet gewählt werden, möglich ist es beispielsweise, eine Spaltbreite von einem Viertel der Ultraschallwellenlänge zu wählen, so dass an der Öffnung des Resonanzrohres ein Schwingungsbauch vorliegt.

Es ist ferner zweckmäßig, in einem dem kühlkörperseitigen Ende des Resonanzrohrs zugewandten Oberflächenbereich des Kühlkörpers wenigstens ein Strömungsleitelement vorzusehen. Hierdurch kann das Abströmen des Ultraschallwindes gezielt gelenkt werden. Dies ist insbesondere vorteilhaft, wenn mehrere Sonotrodenelemente und zugeordnete Resonanzrohre Anwendung finden sollen. Durch geeignete Gestaltung der Strömungsleitelemente kann verhindern werden, dass sich die individuellen Luftströmungen der Sonotrodenelemente gegenseitig negativ beeinflussen.

In einer möglichen Ausgestaltung ist das Strömungsleitelement zur Umleitung einer in Richtung einer Flächennormale der Oberfläche des Kühlkörpers einfallenden Luftströmung um 180° ausgebildet. Der Ultraschallwind wird hier also antiparallel zu seiner Einfallsrichtung abgeleitet. Dies ist besonders zweckmäßig in Kombination mit einem parallel zum Resonanzrohr verlaufenden Luftableitkanal, der die Luftströmung senkrecht von der Oberfläche des Kühlkörpers wegführt.

Besonders bauraumsparend ist jedoch eine alternative Ausgestaltung, in welcher das Strömungsleitelement zur Umleitung einer in Richtung einer Flächennormale der Oberfläche des Kühlkörpers einfallenden Luftströmung um 90° ausgebildet ist.

In diesem Fall wird der einfallende Ultraschallwind somit in Richtung des Kühlkörperrandes abgeleitet. Besonders zweckmäßig ist es dann, wenn sich das Strömungsleitelement bis zu einem Randbereich der Oberfläche des Kühlkörpers erstreckt.

Das Strömungsleitelement kann dabei einen vertieften Kanal in der Oberfläche des Kühlkörpers ausbilden, dessen Breite im Wesentlichen dem Durchmesser des Resonanzrohrs entspricht. Auch eine spiralförmig zum Rand des Kühlkörpers verlaufende Geometrie des Strömungsleitelements ist möglich. Je nach Anordnung der einzelnen Sonotrodenelemente können auch andere Geometrien zweckmäßig sein.

Im Folgenden werden die Erfindung und ihre Ausführungsformen anhand der Zeichnung näher erläutert. Es zeigen:
- FIG 1: eine schematische Schnittdarstellung einer erfindungsgemäßen Kühlvorrichtung,
- FIG 2: eine schematische Schnittdarstellung eines weiteren Ausführungsbeispiels einer erfindungsgemäßen Kühlvorrichtung mit einem Resonanzrohr mit einer Schneidkante,
- FIG 3: eine schematische Schnittdarstellung eines weiteren Ausführungsbeispiels einer erfindungsgemäßen Kühlvorrichtung mit einem Resonanzrohr mit einer Schneidkante,
- FIG 4: eine schematische Schnittdarstellung eines weiteren Ausführungsbeispiels einer erfindungsgemäßen Kühlvorrichtung mit einem Resonanzrohr mit einer Schneidkante,
- FIG 5: eine schematische Schnittdarstellung eines weiteren Ausführungsbeispiels einer erfindungsgemäßen Kühlvorrichtung mit einem Resonanzrohr mit einer Schneidkante und einem Strömungsleitmittel,
- FIG 6: eine schematische Schnittdarstellung des Ausführungsbeispiels der erfindungsgemäßen Kühlvorrichtung gem. FIG 1,
- FIG 7: eine schematische Schnittdarstellung eines weiteren Ausführungsbeispiels einer erfindungsgemäßen Kühlvorrichtung,
- FIG 8: eine schematische Schnittdarstellung der Kühlvorrichtung gem. FIG 6 mit einer Veranschaulichung der thermischen Isolationsschicht an der Kühlkörperoberfläche,
- FIG 9: eine schematische Schnittdarstellung des Ausführungsbeispiels der erfindungsgemäßen Kühlvorrichtung gem. FIG 7 mit einer Veranschaulichung der thermischen Isolationsschicht an der Kühlkörperoberfläche,
- FIG 10: eine perspektivische Ansicht eines Ausführungsbeispiels einer erfindungsgemäßen Kühlvorrichtung mit einer Mehrzahl von Sonotroden,
- FIG 11: eine schematische Schnittdarstellung eines Ausführungsbeispiels einer erfindungsgemäßen Kühlvorrichtung mit einem parallel zum Resonanzrohr verlaufenden Strömungskanal zur Ableitung der erwärmten Luft,
- FIG 12: eine perspektivische Ansicht eines Kühlkörpers mit Strömungsleitelementen zur Verwendung in einem Ausführungsbeispiel einer erfindungsgemäßen Kühlvorrichtung und
- FIG 13: eine perspektivische Ansicht eines alternativen Kühlkörpers mit Strömungsleitelementen zur Verwendung in einem Ausführungsbeispiel einer erfindungsgemäßen Kühlvorrichtung.

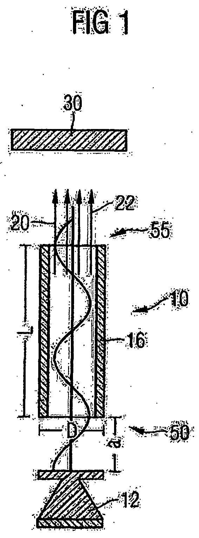

Die in FIG 1 dargestellte Kühlvorrichtung 10 dient zur aktiven Kühlung einer Halbleiterkomponente (in FIG 1 nicht explizit dargestellt). Die Kühlvorrichtung 10 umfasst eine piezoelektrische Sonotrode 12 sowie einen thermisch mit dem Halbleiter gekoppelten Kühlkörper 30. Zwischen Sonotrode 12 und Kühlkörper 30 ist ein kreiszylindrisches Resonanzrohr 16 mit einem ersten 50 und einem zweiten geöffneten Ende 55 derart angeordnet, dass das erste geöffnete Ende 50 zur Sonotrode 12 und das zweite geöffnete Ende 55 des Resonanzrohres 16 zum Kühlkörper 30 weist.

Die Sonotrode 12 schallt in der gezeigten Darstellung in das erste Ende 50 des Resonanzrohres 16 Ultraschallwellen mit einer vorgegebenen Wellenlänge ein. Die Länge L des Resonanzrohres 16 entspricht dabei im Wesentlichen anderthalb Wellenlängen. In weiteren nicht eigens dargestellten Ausführungsbeispielen beträgt die Länge L des Resonanzrohres 16 ein anderes ganzzahliges Vielfaches der halben Wellenlänge. Das erste Ende 50 des Resonanzrohres 16 ist von der Sonotrode 12 um eine halbe Wellenlänge, dem Abstand a, beabstandet. Infolge dieser Anordnung und Ausbildung bilden sich sowohl zwischen erstem Ende 50 und zweitem Ende 55 des Resonanzrohres 16 als auch zwischen Sonotrode 12 und zweitem Ende 55 des Resonanzrohres 16 stehende Ultraschallwellen aus. Der Durchmesser D des Resonanzrohres 16 entspricht dabei einer Wellenlänge. Infolge des Durchmessers ist die Ausbildung stehender Wellen dabei deutlich unterstützt.

Diese stehenden Wellen bilden jeweils an dem zweiten Ende 55 einen Schwingungsbauch 20 aus. Hierdurch wird der neben der eigentlichen Ultraschallschwingung durch die Sonotrode 12 erzeugte Luftstrom, der sogenannte Ultraschallwind, in Richtung der Pfeile 22 verstärkt.

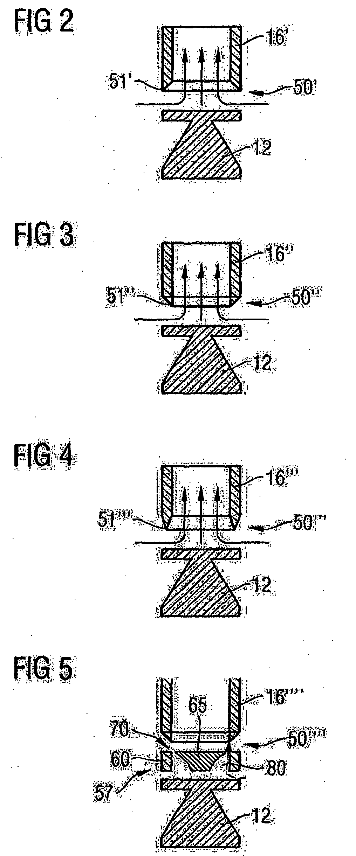

Wie in den in FIG 2 bis 5 dargestellten Ausführungsbeispielen dargestellt, ist die Anregung der stehenden Wellen weiter verbessert, indem an erstem Ende 50', 50'', 50''', 50'''' eine Schneidkante 51', 51'', 51''' vorgesehen ist, welche eine verbesserte Anregung der in das Rohr einströmenden Luft erlaubt.

Dabei ist die Schneidkante 51' wie beispielsweise in FIG 2 gezeigt derart gebildet, dass die Wand des Resonanzrohrs 16' am ersten Ende 50' des Resonanzrohres 16' an der Innenseite zur Richtung der Längserstreckung L des Resonanzrohres 16' geschrägt ist, und zwar derart, dass die Wand am ersten Ende 50' in Richtung auf die Sonotrode 12 spitz zuläuft.

Alternativ kann (FIG 3) die Wand des Resonanzrohrs 16'' am ersten Ende 50'' des Resonanzrohres 16'' an der Außenseite zur Richtung der Längserstreckung L des Resonanzrohres 16'' derart geschrägt sein, dass die Wand am ersten Ende 50'' spitz zuläuft und so eine Schneidkante 51'' bildet.

Ferner kann, wie in FIG 4 dargestellt, auch die Wand des Resonanzrohres 16''' am ersten Ende 50''' des Resonanzrohres sowohl an der Innenseite als auch an der Außenseite zur Richtung der Längserstreckung L des Resonanzrohres 16''' spitz zulaufend geschrägt sein und so eine Schneidkante 51''' bilden.

In der in FIG 5 dargestellten Anordnung (welche im Übrigen der in FIG 3 dargestellten Anordnung entspricht) ist bei der Kühlvorrichtung ein Strömungsleitmittel 57 vorgesehen, mittels welchem strömende Luft gezielt auf eine Schneidkante 51" treffend leitbar ist. Grundsätzlich können in weiteren nicht eigens dargestellten Ausführungsbeispielen auch Schneidkanten wie in FIG 2 oder 4 dargestellt vorhanden sein.

Das Strömungsleitmittel 57 weist ein Strömungsleitrohr 60 auf, welches axial fluchtend zum Resonanzrohr 16'''' sowie zwischen Sonotrode 12 und Resonanzrohr 16'''' angeordnet ist. Das Strömungsleitmittel 57 weist ferner einen innerhalb des Strömungsleitrohres 60 angeordneten massiven Trichter 65 auf, welcher sich längs des Strömungsleitrohres 60 in Richtung auf das Resonanzrohr 16'''' zu aufweitet. Somit bildet sich zwischen Trichter 65 und Strömungsleitrohr 60 ein Strömungskanal 80 aus. Dieser Strömungskanal 80 weist nah dem Resonanzrohr 16'''' eine Austrittsöffnung 70 mit verringerter Querschnittsfläche auf, aus welcher durch das Strömungsleitmittel 57 strömende Luft ausströmen kann. Dabei überlappt diese Austrittsöffnung 70 des Strömungsleitmittels 57 in radialer Richtung mit der Schneidkante 51''.

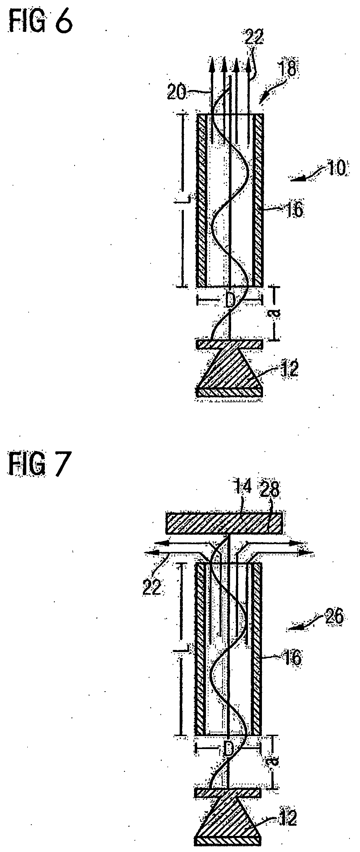

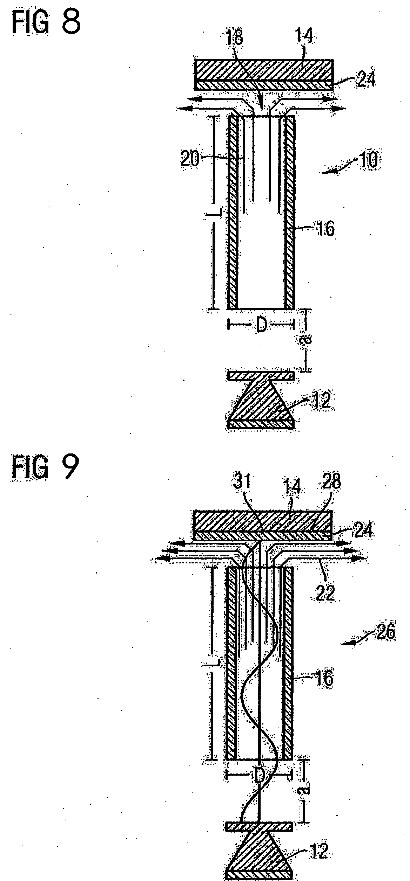

Zur aktiven Kühlung von Halbleiterkomponenten lassen sich erfindungsgemäße Kühlvorrichtungen 10 einsetzen, wie sie zuvor beschrieben worden sind und in FIG 6 und FIG 8 dargestellt sind. Solche Kühlvorrichtungen umfassen wie zuvor bereits beschrieben eine piezoelektrische Sonotrode 12, sowie einen thermisch mit dem Halbleiter gekoppelten Kühlkörper (nunmehr und in den nachfolgend beschriebenen Figuren und der weiteren Beschreibung mit dem Bezugszeichen 14 anstelle des Bezugszeichens 30 gekennzeichnet), zwischen denen ein Resonanzrohr 16 angeordnet ist.

Am kühlkörperseitigen Ende (nunmehr und in den nachfolgend beschriebenen Figuren und der weiteren Beschreibung mit dem Bezugszeichen 18 anstelle des Bezugszeichens 55 gekennzeichnet) des Resonanzrohres bildet sich dabei ein Schwingungsbauch 20 der von der Sonotrode 12 erzeugten Ultraschallschwingung aus. Hierdurch wird der neben der eigentlichen Ultraschallschwingung durch die Sonotrode 12 erzeugte Luftstrom, der sogenannte Ultraschallwind, in Richtung der Pfeile 22 verstärkt.

Wie FIG 8 zeigt, wird der Wärmeabtransport vom Kühlkörper 14 jedoch mitunter durch eine Grenzschicht 24 unbewegter Luft behindert.

Um die Ausbildung der Grenzschicht 24 abzuschwächen, ist in dem in FIG 7 und FIG 9 gezeigten weiteren Ausführungsbeispiel einer erfindungsgemäßen Kühlvorrichtung 26 der Abstand zwischen der Sonotrode 12 und der Oberfläche 28 des Kühlkörpers 14 so gewählt, dass er ein ganzzahliges Vielfaches des Viertels der Wellenlänge des von der Sonotrode 12 erzeugten Ultraschalls beträgt.

Hierdurch entsteht an der Oberfläche 28 des Kühlkörpers 14 ein Schwingungsknoten 31. Zwischen der Sonotrode 12 und der Oberfläche 28 bildet sich also eine stehende Welle aus. Diese verringert die Ausdehnung der Grenzschicht 24, so dass diese eine deutliche geringere Dicke aufweist als bei den zuvor beschriebenen Kühlvorrichtungen 10. Insbesondere werden durch die stehende Welle Wirbel im Bereich der Oberfläche 28 erzeugt, die der Grenzschichtbildung entgegenwirken und den Wärmeabtransport vom Kühlkörper 14 verbessern.

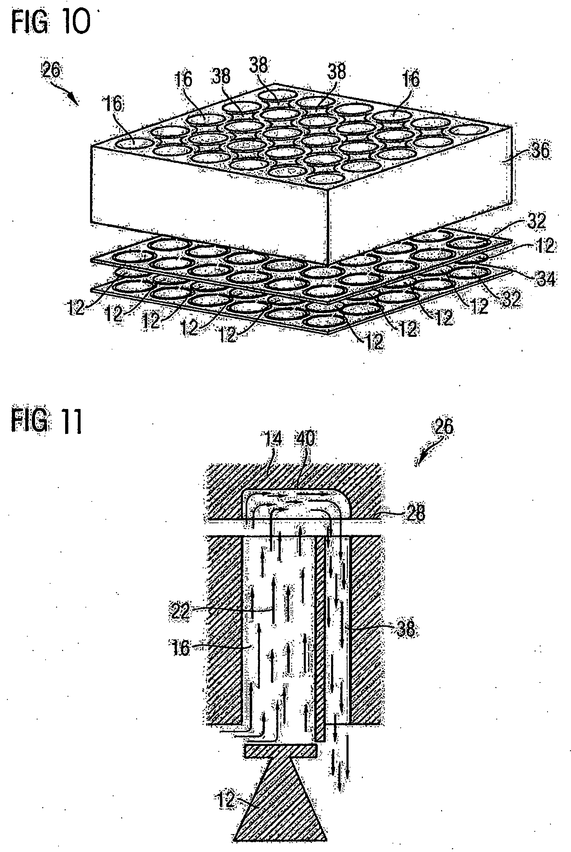

FIG 10 zeigt eine perspektivische Ansicht einer Kühlvorrichtung 26 ohne den Kühlkörper 14. Die Kühlvorrichtung 26 umfasst eine Mehrzahl von piezoelektrischen Sonotroden 12, die zwischen Elektroden 32, 34 eingefasst sind. Die den Sonotroden 12 zugeordneten Resonanzrohre 16 sind gemeinsam in einem Block 36 aufgenommen und der Übersichtlichkeit halber nicht alle bezeichnet.

Zusammen mit den Resonanzrohren 16 sind weitere Strömungskanäle 38, die ebenfalls nicht alle bezeichnet sind, in den Block 36 eingebracht. In Zusammenwirkung mit Strömungsleitelementen 40 auf der Oberfläche 28 des Kühlkörpers 14 dienen diese der Abfuhr erwärmter Luft von der Oberfläche 28.

Wie FIG 11 veranschaulicht, wird der einfallende Ultraschallwind nach Austreten aus dem Resonanzrohr 16 und beim Auftreffen auf das Strömungsleitelement 40 um 180° abgelenkt und in den Strömungskanal 38 geleitet, so dass die erwärmte Luft vom Kühlkörper 14 abgeführt wird. Hierdurch wird insbesondere vermieden, dass sich die Luftströmungen, die von benachbarten Sonotroden 12 erzeugt werden, gegenseitig negativ beeinflussen. Über die gesamte Oberfläche des Kühlkörpers 14 wird somit eine gleichmäßig gute Wärmeabfuhr erzeugt.

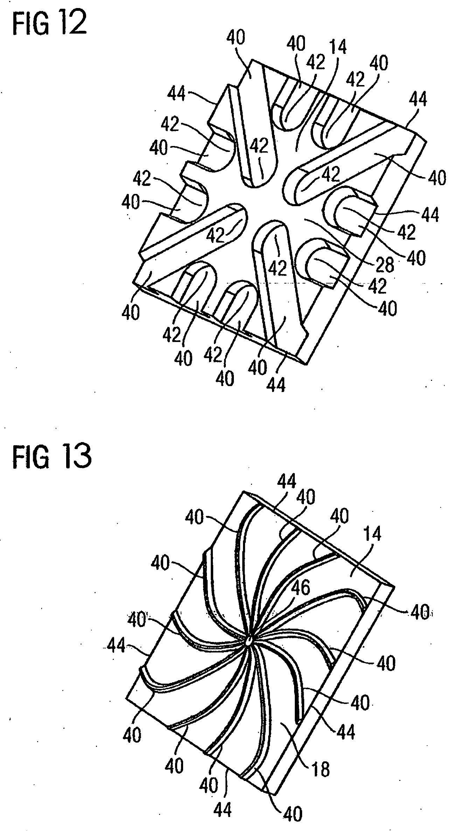

FIG 12 und 13 zeigen alternative Ausgestaltungen der Strömungsleitelemente 40 auf der Oberfläche 28 des Kühlkörpers 14. In der Ausführungsform gemäß FIG 12 sind die Strömungsleitelemente 40 als vertiefte Kanäle ausgebildet, die sich von den Mündungsbereichen 42 der nicht gezeigten Resonanzrohre zum Rand 44 des Kühlkörpers 14 hin erstrecken. Die Kanäle weisen dabei eine Breite auf, die in etwa dem Durchmesser der Resonanzrohre 16 entspricht.

In der Ausführungsform gemäß FIG 13 sind die Strömungsleitelemente 40 als erhabene Stege auf der Oberfläche 28 des Kühlkörpers 14 ausgebildet, die sich von einem Mittelpunkt 46 der Oberfläche 28 zum Rand 44 des Kühlkörpers entlang spiralförmiger Bahnen erstrecken.

Selbstverständlich beschränkt sich die Erfindung nicht auf die in FIG 11 bis 13 gezeigten Geometrien der Strömungsleitelemente 40. Je nach Gestaltung des Kühlkörpers 14 und der abzuführenden Luft- bzw. Wärmemenge können auch andere Ausgestaltungen zweckmäßig sein.

## Patentansprüche

1. Kühlvorrichtung (10) zum Kühlen eines elektronischen Bauelements, insbesondere eines Leistungshalbleiters, mit zumindest einem Sonotrodenelement (12) zur Erzeugung von Ultraschallwellen einer vorgegebenen Wellenlänge, sowie mit einem dem Sonotrodenelement (12) zugeordnetem Resonanzrohr (16) mit einem ersten geöffneten Ende (50) und einem zweiten geöffneten Ende (55),
wobei
das Sonotrodenelement dem ersten Ende (50) näher als dem zweiten Ende (55) angeordnet ist oder das erste Ende (50) zum Sonotrodenelement (12) weist und
wobei der Abstand von Sonotrode (12) und zweitem Ende (55) und/oder der Abstand (L) von erstem Ende (50) und zweitem Ende (55) im Wesentlichen einem ganzzahligen Vielfachen der halben Wellenlänge entspricht.

2. Kühlvorrichtung (10) zum Kühlen eines elektronischen Bauelements, insbesondere eines Leistungshalbleiters, mit zumindest einem Sonotrodenelement (12) zur Erzeugung von Ultraschallwellen einer vorgegebenen Wellenlänge, sowie mit einem dem Sonotrodenelement (12) zugeordnetem Resonanzrohr (16) mit einem ersten geöffneten Ende (50) und einem zweiten geöffneten Ende (55), insbesondere eine Kühlvorrichtung (10) nach Anspruch 1,
wobei
das Sonotrodenelement (12) dem ersten Ende (50) näher als dem zweiten Ende (55) angeordnet ist oder das erste Ende zum Sonotrodenelement (12) weist und
wobei ein Strömungsweg zwischen Sonotrode (12) und zweitem Ende (55) und/oder ein Strömungsweg (L) zwischen erstem Ende (50) und zweitem Ende (55) durch das Resonanzrohr (16) hindurch im Wesentlichen einem ganzzahligen Vielfachen der halben Wellenlänge entspricht.

3. Kühlvorrichtung nach einem der vorhergehenden Ansprüche, ferner umfassend einen mit dem Bauelement koppelbaren Kühlkörper (30), welcher nah dem zweiten Ende (55) des Resonanzrohres (16), insbesondere stirnseitig zu diesem (16) und/oder außerhalb des Resonanzrohres (16) angeordnet ist.

4. Kühlvorrichtung nach einem der vorhergehenden Ansprüche, bei welcher zwischen zweitem Ende (55) des Resonanzrohres (16) und dem Kühlkörper (30) ein Luftspalt vorgesehen ist.

5. Kühlvorrichtung nach einem der vorhergehenden Ansprüche, bei welcher das erste Ende (50'; 50''; 50'''; 50'''') des Resonanzrohres (16) eine Schneidkante (51'; 51''; 51''') aufweist.

6. Kühlvorrichtung nach einem der vorhergehenden Ansprüche, welche ein Strömungsleitmittel (57) aufweist, mittels welchem strömende Luft auf die Schneidkanten (51'') treffend leitbar ist.

7. Kühlvorrichtung nach einem der vorhergehenden Ansprüche, bei welcher das Strömungsleitmittel (57) mindestens einen Strömungskanal (80) aufweist, der sich nah der nah der Schneidkante (51'') verjüngt, wobei sich insbesondere die Querschnittsfläche des Strömungskanals (80) nah der Schneidkante (51'') verringert.

8. Kühlvorrichtung (26) zum Kühlen eines elektronischen Bauelements, insbesondere eines Leistungshalbleiters, mit einem thermisch mit dem Bauelement koppelbaren Kühlkörper (14), sowie mit zumindest einem Sonotrodenelement (12) zur Erzeugung von auf den Kühlkörper (14) hin gerichteten Ultraschallwellen einer vorgegebenen Wellenlänge, sowie mit einem dem Sonotrodenelement (12) zugeordnetem Resonanzrohr (16), welches zwischen dem Sonotrodenelement (12) und dem Kühlkörper (14) angeordnet ist, insbesondere eine Kühlvorrichtung nach einem der Ansprüche 1 bis 7 mit einem thermisch mit dem Bauelement koppelbaren Kühlkörper,
bei welcher
ein Abstand zwischen dem Sonotrodenelement (12) und dem Kühlkörper (14) einem ganzzahligen Vielfachen des Viertels der Wellenlänge entspricht.

9. Kühlvorrichtung (26) nach Anspruch 8,
**dadurch gekennzeichnet, dass** zwischen einem kühlkörperseitigen Ende (18) des Resonanzrohres (16) und dem Kühlkörper (14) ein Luftspalt vorgesehen ist.

10. Kühlvorrichtung (26) nach Anspruch 8 oder 9,
**dadurch gekennzeichnet, dass** in einem dem kühlkörperseitigen Ende (18) des Resonanzrohrs (16) zugewandten Oberflächenbereich (28) des Kühlkörpers (14) wenigstens ein Strömungsleitelement (40) vorgesehen ist.

11. Kühlvorrichtung (26) nach Anspruch 10,
**dadurch gekennzeichnet, dass** das Strömungsleitelement (40) zur Umleitung einer in Richtung einer Flächennormale der Oberfläche (28) des Kühlkörpers (14) einfallenden Luftströmung um 180° ausgebildet ist.

12. Kühlvorrichtung (26) nach Anspruch 11,
**dadurch gekennzeichnet, dass** ein parallel zum Resonanzrohr (16) verlaufender Luftableitkanal (38) vorgesehen ist.

13. Kühlvorrichtung (26) nach Anspruch 10,
**dadurch gekennzeichnet, dass** das Strömungsleitelement (40) zur Umleitung einer in Richtung einer Flächennormale der Oberfläche (28) des Kühlkörpers (14) einfallenden Luftströmung um 90° ausgebildet ist.

14. Kühlvorrichtung (26) nach Anspruch 13,
**dadurch gekennzeichnet, dass** sich das Strömungsleitelement (40) bis zu einem Randbereich (44) der Oberfläche (28) des Kühlkörpers (14) erstreckt.

15. Kühlvorrichtung (26) nach Anspruch 13 oder 14,
**dadurch gekennzeichnet, dass** das Strömungsleitelement (40) einen vertieften Kanal in der Oberfläche (28) des Kühlkörpers (14) ausbildet, dessen Breite im Wesentlichen dem Durchmesser des Resonanzrohrs (16) entspricht.

16. Kühlvorrichtung (26) nach Anspruch 13 oder 14,
**dadurch gekennzeichnet, dass** das Strömungsleitelement (40) eine spiralförmige Bahnkurve beschreibt.

## Claims

1. Cooling device (10) for cooling an electronic component, in particular a power semiconductor, having at least one sonotrode element (12) for generating ultrasonic waves of a predefined wavelength, and having a tuned pipe (16) which is assigned to the sonotrode element (12) and which has a first opened end (50) and a second opened end (55), wherein
the sonotrode element is disposed so as to be closer to the first end (50) than to the second end (55), or the first end (50) faces towards the sonotrode element (12), and
wherein the distance from the sonotrode (12) to the second end (55) and/or the distance (L) from the first end (50) to the second end (55) substantially corresponds to an integral multiple of half of the wavelength.

2. Cooling device (10) for cooling an electronic component, in particular a power semiconductor, having at least one sonotrode element (12) for generating ultrasonic waves of a predefined wavelength, and having a tuned pipe (16) which is assigned to the sonotrode element (12) and which has a first opened end (50) and a second opened end (55), in particular a cooling device (10) according to Claim 1, wherein
the sonotrode element (12) is disposed so as to be closer to the first end (50) than to the second end (55), or the first end faces towards the sonotrode element (12), and wherein a flow path between the sonotrode (12) and the second end (55) and/or a flow path (L) between the first end (50) to the second end (55) through the tuned pipe (16) substantially corresponds to an integral multiple of half of the wavelength.

3. Cooling device according to one of the preceding claims, furthermore comprising a cooling body (30) which is couplable to the component and which is disposed so as to be close to the second end (55) of the tuned pipe (16), in particular so as to be at the face side in relation thereto (16) and/or so as to be outside the tuned pipe (16).

4. Cooling device according to one of the preceding claims, in which an air gap is provided between the second end (55) of the tuned pipe (16) and the cooling body (30).

5. Cooling device according to one of the preceding claims, in which the first end (50'; 50''; 50'''; 50'''') of the tuned pipe (16) displays a cutting edge (51'; 51''; 51''').

6. Cooling device according to one of the preceding claims, which displays a flow-conducting means (57) by means of which flowing air is conductible so as to impinge on the cutting edge (51'').

7. Cooling device according to one of the preceding claims, in which the flow-conducting means (57) displays at least one flow duct (80) which tapers close to the cutting edge (51''), wherein in particular the cross-sectional face of the flow duct (80) is reduced close to the cutting edge (51'').

8. Cooling device (26) for cooling an electronic component, in particular a power semiconductor, having a cooling body (14) which is thermally couplable to the component, and having at least one sonotrode element (12) for generating ultrasonic waves of a predefined wavelength which are directed towards the cooling body (14), and having a tuned pipe (16) which is assigned to the sonotrode element (12) and which is disposed between the sonotrode element (12) and the cooling body (14), in particular a cooling device according to one of claims 1 to 7, having a cooling body which is thermally couplable to the component, in which
a distance between the sonotrode element (12) and the cooling body (14) corresponds to an integral multiple of quarter of the wavelength.

9. Cooling device (26) according to Claim 8, **characterized in that** an air gap is provided between a cooling-body side end (18) of the tuned pipe (16) and the cooling body (14).

10. Cooling device (26) according to Claim 8 or 9, **characterized in that** at least one flow-conducting element (40) is provided in a surface region (28) of the cooling body (14) which faces towards the cooling-body side end (18) of the tuned pipe (16).

11. Cooling device (26) according to Claim 10, **characterized in that** the flow-conducting element (40) is configured for diverting by 180° an air flow which enters in the direction of a surface normal of the surface (28) of the cooling body (14).

12. Cooling device (26) according to Claim 11, **characterized in that** an air outlet duct (38) which runs parallel to the tuned pipe (16) is provided.

13. Cooling device (26) according to Claim 10, **characterized in that** the flow-conducting element (40) is configured for diverting by 90° an air flow which enters in the direction of a surface normal of the surface (28) of the cooling body (14).

14. Cooling device (26) according to Claim 13, **characterized in that** the flow-conducting element (40) extends up to a peripheral region (44) of the surface (28) of the cooling body (14).

15. Cooling device (26) according to Claim 13 or 14, **characterized in that** the flow-conducting element (40), in the surface (28) of the cooling body (14), configures a sunken duct the width of which substantially corresponds to the diameter of the tuned pipe (16).

16. Cooling device (26) according to Claim 13 or 14, **characterized in that** the flow-conducting element (40) describes a helical path curve.

## Revendications

1. Dispositif de refroidissement (10) pour refroidir un composant électronique, en particulier un semi-conducteur de puissance, avec au moins un élément à sonotrode (12) pour générer des ondes ultrasoniques d'une longueur d'onde déterminée au préalable, ainsi qu'avec un tube de résonance (16) affecté à l'élément à sonotrode (12) avec une première extrémité ouverte (50) et une deuxième extrémité ouverte (55), dans lequel l'élément à sonotrode est disposé plus près de la première extrémité (50) que de la deuxième extrémité (55) ou la première extrémité (50) est dirigée vers l'élément à sonotrode (12) et dans lequel l'écartement entre le sonotrode (12) et la deuxième extrémité (55) et/ou l'écartement (L) entre la première extrémité (50) et la deuxième extrémité (55) correspond essentiellement à un multiple entier de la demie longueur d'onde.

2. Dispositif de refroidissement (10) pour refroidir un composant électronique, en particulier un semi-conducteur de puissance, avec au moins un élément à sonotrode (12) pour générer des ondes ultrasoniques d'une longueur d'onde déterminée au préalable, ainsi qu'avec un tube de résonance (16) affecté à l'élément à sonotrode (12) avec une première extrémité ouverte (50) et une deuxième extrémité ouverte (55), en particulier un élément de refroidissement (10) selon la revendication 1, dans lequel l'élément à sonotrode (12) est disposé plus près de la première extrémité (50) que de la deuxième extrémité (55) ou la première extrémité est dirigée vers l'élément à sonotrode (12) et dans lequel une voie d'écoulement entre le sonotrode (12) et la deuxième extrémité (55) et/ou une voie d'écoulement (L) entre la première extrémité (50) et la deuxième extrémité (55) à travers le tube de résonance (16) correspond essentiellement à un multiple entier de la demie longueur d'onde.

3. Dispositif de refroidissement selon l'une des revendications précédentes, comprenant en outre un corps de refroidissement (30) susceptible d'être couplé au composant, disposé à proximité de la deuxième extrémité (55) du tube de résonance (16), en particulier sur le côté frontal par rapport à celui-ci (16) et/ou en dehors du tube de résonance (16).

4. Dispositif de refroidissement selon l'une des revendications précédentes, dans lequel un entrefer est prévu entre la deuxième extrémité (55) du tube de résonance (16) et le corps de refroidissement (30).

5. Dispositif de refroidissement selon l'une des revendications précédentes, dans lequel la première extrémité (50' ; 50" ; 50"' ; 50"") du tube de résonance (16) présente un bord de coupe (51' ; 51''; 51"').

6. Dispositif de refroidissement selon l'une des revendications précédentes, lequel présente un moyen de direction de l'écoulement (57) via lequel l'écoulement d'air peut être dirigé de manière ciblée sur les bords de coupe (51").

7. Dispositif de refroidissement selon l'une des revendications précédentes, dans lequel le moyen de direction de l'écoulement (57) présente au moins un canal d'écoulement (80) qui se rétrécit à proximité du bord de coupe (51"), dans lequel la surface de section du canal d'écoulement (80) se rétrécit en particulier à proximité du bord de coupe (51").

8. Dispositif de refroidissement (26) pour refroidir un composant électronique, en particulier un semi-conducteur de puissance, avec un corps de refroidissement (14) susceptible d'être couplé thermiquement au composant, ainsi qu'avec au moins un élément à sonotrode (12) afin de générer des ondes ultrasoniques d'une longueur d'onde déterminée au préalable dirigées vers le corps de refroidissement (14), ainsi qu'avec un tube de résonance (16) affecté à l'élément à sonotrode (12), lequel est disposé entre l'élément à sonotrode (12) et le corps de refroidissement (14), en particulier un dispositif de refroidissement selon l'une des revendications 1 à 7 avec un corps de refroidissement susceptible d'être couplé thermiquement avec le composant, dans lequel un écartement entre l'élément à sonotrode (12) et le corps de refroidissement (14) correspond à un multiple entier du quart de la longueur d'onde.

9. Dispositif de refroidissement (26) selon la revendication 8, **caractérisé en ce qu'**un entrefer est prévu entre une extrémité côté corps de refroidissement (18) du tube de résonance (16) et le corps de refroidissement (14).

10. Dispositif de refroidissement (26) selon la revendication 8 ou 9, **caractérisé en ce qu'**au moins un élément de direction de l'écoulement (40) est prévu dans une extrémité (18) du tube de résonance (16) dirigée vers la zone de surface (28) du corps de refroidissement (14).

11. Dispositif de refroidissement (26) selon la revendication 10, **caractérisé en ce que** l'élément de direction de l'écoulement (40) est exécuté afin de dévier de 180° un écoulement d'air s'écoulant dans le sens d'une normale à la surface (28) du corps de refroidissement (14).

12. Dispositif de refroidissement (26) selon la revendication 11, **caractérisé en ce qu'**un canal de déviation d'air (38) s'étendant parallèlement au tube de résonance (16) est prévu.

13. Dispositif de refroidissement (26) selon la revendication 10, **caractérisé en ce que** l'élément de direction de l'écoulement (40) est exécuté afin de dévier de 90° un écoulement d'air s'écoulant dans le sens d'une normale à la surface (28) du corps de refroidissement (14).

14. Dispositif de refroidissement (26) selon la revendication 13, **caractérisé en ce que** l'élément de direction de l'écoulement (40) s'étend jusqu'à une zone périphérique (44) de la surface (28) du corps de refroidissement (14).

15. Dispositif de refroidissement (26) selon la revendication 13 ou 14, **caractérisé en ce que** l'élément de direction de l'écoulement (40) forme un canal évidé à la surface (28) du corps de refroidissement (14), dont la largeur correspond essentiellement au diamètre du tube de résonance (16).

16. Dispositif de refroidissement (26) selon la revendication 13 ou 14, **caractérisé en ce que** l'élément de direction de l'écoulement (40) décrit un tracé spiroïdal.
